# EUROPÄISCHE PATENTSCHRIFT

(11) **EP 1 094 128 B1**
(45) Veröffentlichungstag und Bekanntmachung des Hinweises auf die Patenterteilung: **28.12.2005**
(21) Anmeldenummer: 99121189.7
(22) Anmeldetag: 22.10.1999
(51) Int. Cl.: C23C 16/04

(54) **Verfahren zur Innenbeschichtung von Hohlkörpern**
Process for interior coating of hollow bodies
Procédé pour revêtement de l'intérieur de corps creux

(43) Veröffentlichungstag der Anmeldung: 25.04.2001
(73) Patentinhaber: INPRO Innovationsgesellschaft für fortgeschrittene Produktionssysteme in der Fahrzeugindustrie mbH, 10587 Berlin (DE)
(72) Erfinder: Gleich, Henning, 47259 Duisburg (DE); Heckel, Horst, 64331 Weiterstadt (DE); Hoyer, Olaf, 16727 Schwante (DE); Kempen, Thomas, 12043 Berlin (DE); Steinhardt, Ingolf, 10585 Berlin (DE)
(74) Vertreter: Hoffmann, Klaus-Dieter

(56) Entgegenhaltungen:
- FR-A- 2 695 506
- US-A- 3 658 585

## Beschreibung

Die Erfindung betrifft ein Verfahren zur gesteuerten Führung von für die Plasmabehandlung komplexer Hohlkörpergeometrien notwendiger Arbeitsgase, bei dem die Arbeitsgase über mindestens einen Einlaß und mindestens einen Auslaß in bzw. aus dem innen zu beschichtenden Hohlkörper in wechselseitiger Strömung geführt werden.

Herkömmlich erfolgt die Zuführung und Abführung der für die Plasmabehandlung von Hohlkörpern notwendigen Arbeitsgase über einen am Hohlkörper vorgesehenen Einlaß und zu diesem beabstandeten Auslaß, wobei die Arbeitsgase nach dem Einstrom-Prinzip durch den Hohlkörper geführt werden. Bei komplexen Hohlkörpergeometrien und durch diese bedingten verhältnismäßig langen oder komplexen Gasleitungswegen ist jedoch mit dem herkömmlichen Einstrom-Prinzip eine gleichmäßige Plasmabehandlung über die gesamte Bauteiloberfläche nicht zu gewährleisten.

Nach der FR-A-2 695 506 ist es bekannt, bei einer plasmaunterstützten Beschichtung der Innenoberfläche von Umhüllungen für nukleares Brennmaterial die endseitigen Bereiche der Umhüllungen abwechslend zur Erzeugung des Plasmas und zum Abpumpen zu verwenden und eine wechselseitige Strömung des Arbeitsgases zu erzeugen.

Der Erfindung liegt daher die Aufgabe zugrunde, ein Verfahren der eingangs erwähnten Art zur Verfügung zu stellen, mit dem eine optimierte Arbeitsgasführung und -ansteuerung zur Plasmabehandlung von komplexen Hohlkörpergeometrien zwecks gleichmäßiger Behandlung bzw. Beschichtung der Innenoberfläche der Hohlkörper in konstanter Stärke gewährleistet werden.

Diese Aufgabe wird erfindungsgemäß dadurch gelöst, daß in dem Hohlkörper die wechselseitige Arbeitsgasströmung (Gegenströmung) über die Dauer der Plasmabehandlung zwischen dem mindestens einen Einlaß und dem zu diesem beabstandeten mindestens einen Auslaß erzeugt wird, indem während einer ersten Behandlungszeit tₐ die Zuführung und die Abführung des Arbeitsgases über den Einlaß bzw. den zu diesem beabstandeten Auslaß erfolgt und das Arbeitsgas sich als eine erste Behandlungsschicht a im Hohlkörper abscheidet, und daß während einer sich unmittelbar anschließenden zweiten Behandlungszeit t_{b} durch Umschaltung der Zuführung und der Abführung des Arbeitsgases diese über den Auslaß bzw. den Einlaß erfolgen und das Arbeisgas sich als eine zweite Behandlungsschicht b im Hohlkörper abschiedet, die als Summe mit der ersten Behandlungsschicht a eine gleichmäßige Gesamtbehandlungsschicht a + b auf der Innenwand des Hohlkörpers erzeugt, wobei die Öffnungsquerschnitte des mindestens einen Einlasses und des mindestens einen Auslasses des Arbeitsgases in Abhängigkeit von der jeweiligen Verweilzeit tₐ und t_{b} der Arbeitsgase im Hohlkörper gesteuert werden.

Vorteilhafterweise wird die Gegenströmung des Arbeitsgases über die Dauer der Plasemabehandlung alternierend erzeugt. Desweiteren kann bevorzugt besonders bei rohrförmigen Hohlkörpern in unmittelbarer Nähe des mindestens einen Gasauslasses und des zu diesem beabstandeten mindestens einen Gasauslasses am Hohlkörper in paarweiser Anordnung jeweils ein weiterer Gaseinlaß bzw. ein Gasauslaß vorgesehen werden, wobei über die Behandlungszeit t die jeweils einander zugeordneten Gaseinlässe und Gasauslässe der paarweisen Anordnungen wechselseitig freigeschaltet werden, die Arbeitsgase dabei im alternierenden Gegenstromprinzip in den Hohlkörper ein- und ausgeführt werden und die gesamte Innenoberfläche des Hohlkörpers gleichmäßig beschichtet wird.

Als Zuführungen des Arbeitsgases in die jeweilige Hohlkörpergeometrie können Schläuche oder Rohre Verwendung finden, die über entsprechende Abdic htungen aus der Arbeitskammer nach außen geführt werden. Die Steuerung der Arbeitsgaszuführung, insbesondere des Gasflusses kann außerhalb oder innerhalb der Arbeitskammer über Steuersysteme realisiert werden. Die Auslässe des Arbeitsgases, die über entsprechende Steuersysteme steuerbar sind, können unmittelbar aus der Arbeitskammer oder über Schläuche oder Rohre zu einer Vakuumabsaugung führen Bevorzugt erfolgt die Steuerung des Arbeitsgasstroms in und aus den Einlässen bzw. Auslässen z.B. als Trapezfunktion, Rampenfunktion, Sägezahnfunktion oder Sinufunktion.

An komplexen Hohlkörpern wird bevorzugt ein Vielzahl der paarweisen Anordnung von Gaseinlaß und zugeordnetem Gasauslaß beabstandet hintereinander vorgesehen, so daß die Innenoberfläche des Hohlkörpers gleichmäßig von dem Arbeitsgas überstrichen werden kann.

Das erfindungsgemäße Verfahren ermöglicht durch die gesteuerte wechselseitige Strömung oder Gegenströmung des Arbeitsgases in dem Hohlkörper eine besonders gleichmäßige Beschichtung der Innenoberfläche des letzteren, wie Permeationsmessungen an plasmapolymerisierten Rohren erwiesen haben. Weiterhin werden durch die Erfindung in vorteilhafter Weise lange oder komplexe Gasleitungswege ausgeglichen, die durch entsprechende Hohlkörpergeometrien gegeben sind. So kann durch die wechselseitige Schaltung der einander zugeordneten Arbeitsgaszuführungen und - abführungen der entspechenden paarweisen Anordnungen die zu behandelnde Innenoberfläche des Hohlkörpers einer sehr gleichmäßigen Behandlung unterzogen werden, wie eingehende Untersuchungen ergeben haben.

Das erfindungsgemäße Verfahren wird nun anhand der Zeichnungen erläutert. In diesen sind:
**Fig. 1** eine schematische Darstellung eines Hohlkörpers mit an dessen gegenüberliegenden Enden paarweisen Anordnungen je eines Gaseinlasses und eines Gasauslasses, wobei Meßpunkte für eine Permeationsmessung angezeigt sind,
**Fig. 2** ein Diagramm, aus dem die prozentuale permeierte Stoffmenge an den in Fig. 1 ersichtlichen Meßpunkten einer Permeationsmessung an plasmapolymerisierten Rohren im Vergleich bei Einsatz eines herkömmlichen, auf dem Einstrom-Prinzip basierenden Verfahrens und des auf dem Gegenstrom - Prinzip basierenden Verfahrens gemäß der Erfindung zeigt,
**Fig. 3** eine schematische Längsschnittansicht des Hohlkörpers, aus der die Behandlungsphasen der Hohlkörperinnenoberfläche während der Arbeitsgaszuführungen gemäß dem alternierenden Gegenstromprinzip nach Fig. 2 hervorgeht, und
**Fig. 4** ein Diagramm, aus dem der Verlauf der wechselseitigen Gaszuführung des Arbeitsgases durch die jeweiligen Gaseinlässe der gegenüberliegenden paarweisen Anordnungen über die Zeit der Plasmabehandlung des Hohlkörpers bei Steuerung der beiden Gasströme als Trapezfunktion hervorgeht,

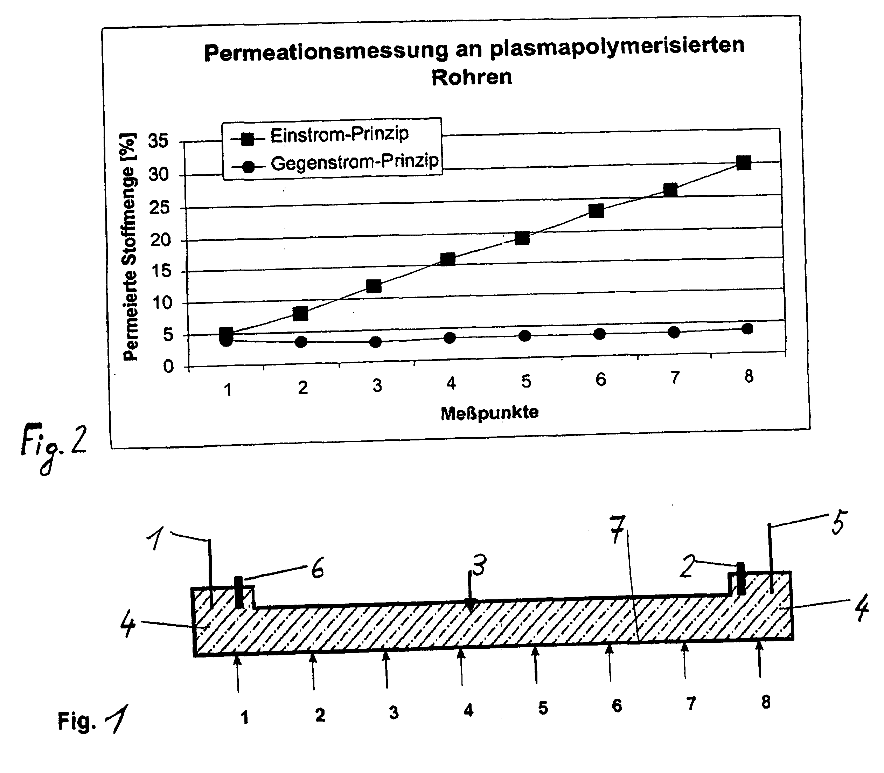

Fig. 1 verdeutlicht eine bevorzugte Ausführungsform der Erfindung, nach der an den einander gegenüberliegenden, im Querschnitt vergrößerten Enden 4 eines rohrartigen Hohlkörpers 3 eine paarweise Anordnung eines Gaseinlasses 1 und eines Gasauslasses 6 einerseits und eine paarweise Anordnung eines Gaseinlasses 5 und eines Gasauslasses 2 anderseits vorgesehen werden, so daß eine wechselseitige Strömung oder Gegenströmung des Arbeitsgases erzeugt werden kann, und zwar vom Gaseinlaß 1 zum Gasauslaß 2 einerseits und vom Gaseinlaß 5 zum Gasauslaß 6 anderseits. Über die die Zeit der Plasmabehandlung werden der Gaseinlaß 1 und der Gasauslaß 2 sowie der Gaseinlaß 5 und der Gasauslaß 6 der jeweiligen Arbeitsgase alternierend geschaltet, so daß die Zuführung und Ansteuerung der für die Plasmabehandlung notwendigen Arbeitsgase mittels des alternierenden Gegenstromprinzips optimiert werden können und die gesamte plasmabehandelte Innenoberfläche 7 des Hohlkörpers 3 gleichmäßig beschichtet wird.

Als Maß für die Güte der Beschichtung auf der Innenoberfläche 7 des Hohlkörpers 3 wird an den in Fig. 1 gezeigten acht Meßpunkten des letzteren die permeierte prozentuale Stoffmenge ermittelt. Als Beispiel einer derartigen Permeationsmessung an plasmapolymerisierten Rohren ist in Gegenüberstellung einer Plasmabehandlung der Innenoberfläche der Rohre nach dem herkömmlichen Einstrom-Prinzip und des Gegenstromprinzips des Arbeitsgase gemäß der Erfindung die prozentuale permeierte Stoffmenge als Maß für die Schichtgüte bei den Barriereschichten in Bezug auf die acht Meßpunkte nach Fig. 1 aufgetragen. Bei der Verfahrensweise nach dem herkömmlichen Einstrom-Prinzip wurde das Arbeitsgas über den Gaseinlaß 1 zugeführt und über den Gasauslaß 2 abgelassen. Aus dem Diagramm geht deutlich hervor, daß mit zunehmenden Abstand zur Arbeitsgaszuführung die Barrierewirkung abnimmt, d.h. die Schichtdicke wird geringer. Demgegenüber ist die permeierte Stoffmenge, die bei der nach dem Gegenstrom-Prinzip beschichteten Innenoberfläche 7 des Hohlkörpers 3 gemessen wurde, über die gesamte Rohrlänge gleich, d.h. es liegt eine konstante Schichtdicke vor.

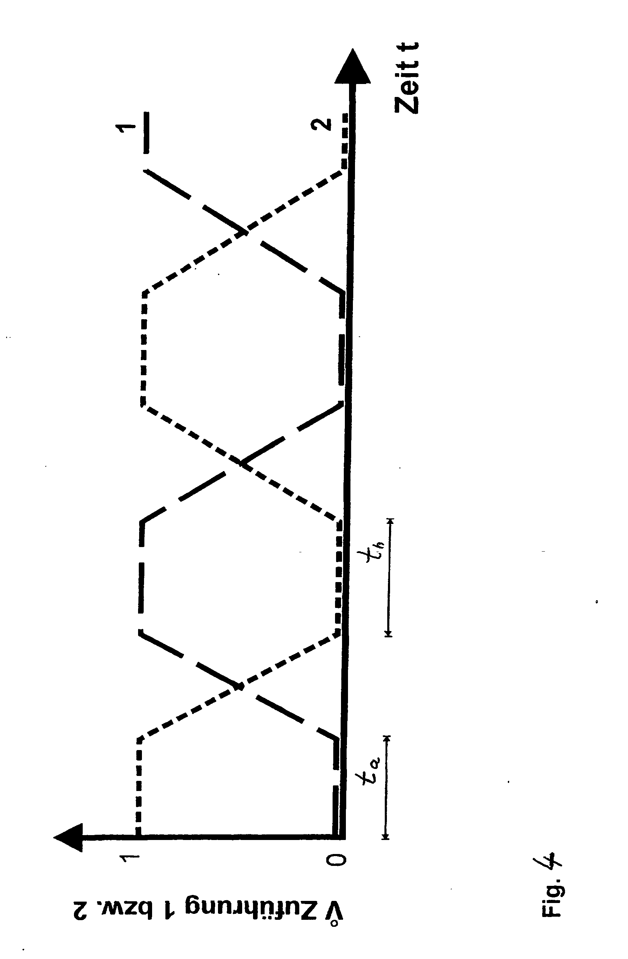

Die Steuerung des Arbeitsgasstroms der Gaszuführung als auch der Gasabführung kann z.B. nach einer Trapezfunktion erfolgen. So zeigt das Diagramm der Fig. 4 beispielhaft für die Verfahrensweise gemäß Fig. 1 den Verlauf der wechselseitigen Gaszuführung des Arbeitsgases durch die jeweiligen Gaseinlässe 1 und 5 der gegenüberliegenden paarweisen Anordnungen über die Zeit der Plasmabehandlung des Hohlkörpers 3 nach einer solchen Trapezfunktion.

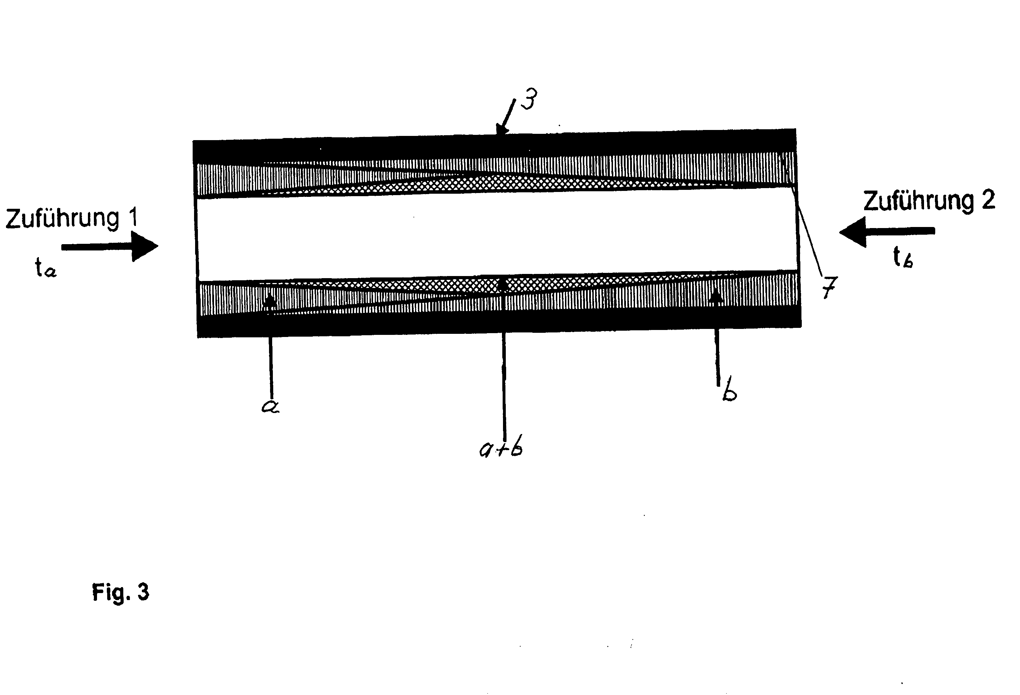

Aus Fig. 3, die eine schematische Längsschnittansicht eines normal mit einem Gaseinlaß 1 und einem Gasauslaß 2 versehenen rohrförmigen Hohlkörpers 3 zeigt, gehen die Behandlungsphasen der Hohlkörperinnenoberfläche 7 während der Arbeitsgaszuführungen gemäß dem alternierenden Gegenstrom-Prinzip nach Fig. 2 hervor. Während der Behandlungszeit tₐ (Fig. 3) durch das über den Gaseinlaß 1 in den Hohlkörper 3 zugeführte Arbeitsgas scheidet sich dieses als Behandlungsschicht a auf der Innenoberfläche 7 des Hohlkörpers 3 ab. Nach Umschaltung der Zuführung des Arbeitsgases durch den Gasauslaß 2 im Sinne des Gegenstrom-Prinzips scheidet sich das Arbeitsgas während einer Behandlungszeit t_{b} (Fig. 3) als Behandlungsschicht b auf der Innenoberfläche 7 des Hohlkörpers 3 ab, die als Summe mit der Behandlungsschicht tₐ eine gleichmäßige Behandlungsschicht a + b auf der Innenoberfläche 7 des Hohlkörpers 3 erzeugt.

## Patentansprüche

1. Verfahren zur gesteuerten Führung von für die Plasmabehandlung komplexer Hohlkörpergeometrien notwendiger Arbeitsgase, bei dem die Arbeitsgase über mindestens einen Einlaß und mindestens einen zu diesem beabstandeten Auslaß in bzw. aus dem innen zu beschichtenden Hohlkörper in wechselseitiger Strömung geführt werden, **dadurch gekennzeichnet, daß** in dem Hohlkörper (3) die wechselseitige Arbeitsgasströmung (Gegenströmung) über die Dauer der Plasmabehandlung zwischen dem mindestens einen Einlaß (1) und dem zu diesem beabstandeten mindestens einen Auslaß (2) erzeugt wird, indem während einer ersten Behandlungszeit (tₐ) die Zuführung und die Abführung des Arbeitsgases über den Einlaß (1) bzw. den zu diesem beabstandeten Auslaß (2) erfolgt und das Arbeitsgas sich als eine erste Behandlungsschicht (a) im Hohlkörper (3) abscheidet, und daß während einer sich unmittelbar anschließenden zweiten Behandlungszeit (t_{b}) durch Umschaltung der Zuführung und der Abführung des Arbeitsgases diese über den Auslaß (2) bzw. den Einlaß (1) erfolgen und das Arbeitsgas sich als eine zweite Behandlungsschicht (b) im Hohlkörper (3) abscheidet, die als Summe mit der ersten Behandlungsschicht (a) eine gleichmäßige Gesamtbehandlungsschicht (a + b) auf der Innenwand (7) des Hohlkörpers (3) erzeugt, wobei die Öffnungsquerschnitte des mindestens einen Einlasses (1) und des mindestens einen Auslasses (2) des Arbeitsgases in Abhängigkeit von der jeweiligen notwendigen Verweilszeit (tₐ und t_{b}) der Arbeitsgase im Hohlkörper (3) gesteuert werden.

2. Verfahren nach Anspruch 1, **dadurch gekennzeichnet, daß** in unmittelbarer Nähe des mindestens einen Gaseinlasses (1) und des zu diesem beabstandeten, mindestens einen Gasauslasses (2) am Hohlkörper (3) in paarweiser Anordnung jeweils ein weiterer Gasauslaß (5) bzw. ein Gaseinlaß (6) vorgesehen wird, und daß über die Beschichtungszeit (t) die jeweils einander zugeordneten Gaseinlässe (1; 5) und Gasauslässe (2; 6) der paarweisen Anordnungen (1, 2; 5, 6) wechselseitig freigeschaltet werden und die Arbeitsgase dabei im alternierenden Gegenstromprinzip in den Hohlkörpers (3) ein- und ausgeführt werden, wobei die gesamte Innenoberfläche (7) des Hohlkörpers (3) gleichmäßig beschichtet wird.

3. Verfahren nach Anspruch 2, **dadurch gekennzeichnet, daß** die Steuerung des Arbeitsgasstroms durch die Gaseinlässe (1; 5) und die Gasauslässe (2; 6) als Trapezfunktion erfolgt.

4. Verfahren nach Anspruch 2, **dadurch gekennzeichnet, daß** die Steuerung des Arbeitsgasstroms durch die Gaseinlässe (1; 5) und die Gasauslässe (2; 6) als Rampenfunktion erfolgt.

5. Verfahren nach Anspruch 2, **dadurch gekennzeichnet, daß** die Steuerung des Arbeitsgastroms durch die Gaseinlässe (1; 5) und die Gasauslässe (2; 6) als Sägezahnfunktion erfolgt.

6. Verfahren nach Anspruch 2, **dadurch gekennzeichnet, daß** die Steuerung des Arbeitsgasstroms durch die Gaseinlässe (1; 5) und die Gasauslässe (2; 6) als Sinusfunktion erfolgt.

7. Verfahren nach Anspruch 2 bis 6, **dadurch gekennzeichnet, daß** eine Vielzahl der paarweisen Anordnung von Gaseinlaß (1; 5) und zugeordnetem Gasauslaß (2; 6) an dem Hohlkörper (3) beabstandet hintereinander vorgesehen wird.

## Claims

1. A method for controlled guidance of working gases required for the plasma treatment of complex hollow-body geometries, wherein the working gases are guided via at least one inlet and at least one outlet at a distance therefrom in or out of the hollow body to be coated on the inside in an alternate flow, **characterised in that** in said hollow body (3) said alternate working gas flow (counterflow) is produced over the duration of the plasma treatment between the at least one inlet (1) and the at least one outlet (2) at a distance therefrom, wherein during a first treatment time (tₐ) the supply and removal of working gas takes place via the inlet (1) or the outlet (2) at a distance therefrom and the working gas is deposited as a first treatment layer (a) in the hollow body (3) and that during an immediately following second treatment time (t_{b}) by switching the supply and the removal of the working gas, these take place via the outlet (2) or the inlet (1) and the working gas is deposited as a second treatment layer (b) in the hollow body (3) which, combined with the first treatment layer (a), produces a uniform total treatment layer (a + b) on the inner wall (7) of the hollow body (3) wherein the opening cross-section of the at least one inlet (1) and the at least one outlet (2) of the working gas are controlled as a function of the respectively required dwell time (tₐ and t_{b}) of the working gas in the hollow body (3).

2. The method according to claim 1, **characterised in that** in the immediate vicinity of the at least one gas inlet (1) and the at least one gas outlet (2) at a distance therefrom, respectively one further gas outlet (5) or one gas inlet (6) is provided in a pairwise arrangement on the hollow body (3) and that over the coating time (t) the gas inlets (1; 5) and gas outlets (2; 6) respectively associated with one another in the pairwise arrangements (1, 2; 5, 6) are alternately opened and the working gases are supplied and removed according to an alternating counterflow principle in the hollow body (3), wherein the entire inner surface (7) of the hollow body (3) is uniformly coated.

3. The method according to claim 2, **characterised in that** the working gas flow through the gas inlets (1; 5) and the gas outlets (2; 6) is controlled as a trapezoidal function.

4. The method according to claim 2, **characterised in that** the working gas flow through the gas inlets (1; 5) and the gas outlets (2; 6) is controlled as a ramp function.

5. The method according to claim 2, **characterised in that** the working gas flow through the gas inlets (1; 5) and the gas outlets (2; 6) is controlled as a sawtooth function.

6. The method according to claim 2, **characterised in that** the working gas flow through the gas inlets (1; 5) and the gas outlets (2; 6) is controlled as a sine function.

7. The method according to claims 2 to 6, **characterised in that** a plurality of pairwise arrangements of gas inlet (1; 5) and associated gas outlet (2; 6) are provided at a distance from one another, one after the other, on the hollow body (3).

## Revendications

1. Procédé pour le guidage commandé de gaz de travail nécessaire au traitement plasmatique de géométries complexes de corps creux, où les gaz de travail sont guidés par au moins une entrée et au moins une sortie à distance de l'entrée dans respectivement hors de l'intérieur du corps creux à revêtir dans un courant alternatif, **caractérisé en ce que** dans le corps creux (3), le courant de gaz de travail alterné (contre courant) est généré sur la durée du traitement de plasma entre au moins une entrée (1) et au moins une sortie (2) à distance de cette entrée, dans le fait que pendant une première période de traitement (tₐ), l'amenée et l'évacuation du gaz de travail s'effectuent par l'entrée (1) respectivement par la sortie (2) et le gaz de travail se dépose dans le corps creux (3) en tant que première couche de traitement (a) et **en ce que** pendant un second temps de traitement (t_{b}) immédiatement consécutif, par commutation de l'amenée et de l'évacuation du gaz de travail, celles-ci s'effectuent par la sortie (2) respectivement par l'entrée (1) et le gaz de travail se dépose en tant que seconde couche de dépôt (b) dans le corps creux (3) qui génère en s'ajoutant à la première couche de traitement (a) une couche homogène globale de traitement (a+ b ) sur la paroi interne (7) du corps creux (3), les sections d'ouverture d'au moins une entrée (1) et d'au moins une sortie (2) du gaz de travail sont commandées en fonction du temps de séjour respectif nécessaire (tₐ et t_{b}) des gaz de travail dans le corps creux (3).

2. Procédé selon la revendication 1, **caractérisé en ce qu'**à proximité immédiate d'au moins une entrée de gaz (1) et d'au moins une sortie de gaz (2) à distance de l'entrée, il est prévu sur le corps creux (3) en disposition par paire (1, 2; 5, 6) respectivement une autre sortie de gaz (5) respectivement une entrée de gaz (6) et **en ce que** pendant le temps de dépôt (t), les entrées de gaz (1; 5) et les sorties de gaz (2; 6) respectivement associées entre elles sont libérées en alternance et les gaz de travail sont entrés et sortis dans le corps creux (3) selon le principe alterné du contre courant, l'ensemble de la surface interne (7) du corps creux (3) étant revêtu uniformément.

3. Procédé selon la revendication 2, **caractérisé en ce que** la commande du courant de gaz de travail s'effectue comme une fonction trapézoïdale par les entrées de gaz (1; 5) et les sorties de gaz (2; 6).

4. Procédé selon la revendication 2, **caractérisé en ce que** la commande du courant de gaz de travail s'effectue comme une fonction de rampe par les entrées de gaz (1; 5) et les sorties de gaz (2; 6).

5. Procédé selon la revendication 2, **caractérisé en ce que** la commande du courant de gaz de travail s'effectue comme une fonction en dent de scie par les entrées de gaz (1; 5) et les sorties de gaz (2; 6).

6. Procédé selon la revendication 2, **caractérisé en ce que** la commande du courant de gaz de travail s'effectue comme une fonction sinusoïdale par les entrées de gaz (1; 5) et les sorties de gaz (2; 6).

7. Procédé selon les revendications 2 à 6, **caractérisé en ce qu'**un grand nombre de la disposition par paire de l'entrée de gaz (1; 5) et de la sortie de gaz associée (2; 6) sont prévus sur le corps creux (3) à distance les uns derrière les autres.
